# EUROPÄISCHE PATENTSCHRIFT

(11) **EP 3 706 315 B1**
(45) Veröffentlichungstag und Bekanntmachung des Hinweises auf die Patenterteilung: **14.01.2026**
(21) Anmeldenummer: 20168698.7
(22) Anmeldetag: 26.01.2017
(51) Int. Cl.: H03K 17/975, G06F 3/0362, G06F 3/039, G06F 3/02, G06F 3/0354

(54) **SCHALT-VORRICHTUNG ZUR UMWANDLUNG EINER MANUELLEN UND/ODER MECHANISCHEN ZUSTELLBEWEGUNG IN EIN SCHALTSIGNAL**
SWITCHING DEVICE FOR CONVERTING A MANUAL AND/OR MECHANICAL FEED MOTION INTO A SWITCHING SIGNAL
DISPOSITIF DE COMMUTATION DESTINÉ À LA CONVERSION D'UN MOUVEMENT DE RÉGLAGE MÉCANIQUE ET/OU MANUEL EN UN SIGNAL DE COMMUTATION

(43) Veröffentlichungstag der Anmeldung: 09.09.2020
(62) Teilanmeldung aus: 17153284.9
(73) Patentinhaber: RAFI GmbH & Co. KG, 88276 Berg (DE)
(72) Erfinder: Bulach, Eric, 88074 Meckenbeuren (DE); Fleischer, Frank, 88368 Bergatreute (DE); Wahl, Simon, 88410 Bad Wurzach (DE); Mennig, Sebastian, 88353 Kißlegg (DE); Hofmann, Steffen, 88364 Wolfegg (DE)
(74) Vertreter: Christ, Niko

(56) Entgegenhaltungen:
- WO-A1-2006/036950
- DE-A1- 102009 032 634
- US-A1- 2006 256 090
- US-A1- 2012 075 486

## Beschreibung

Die Erfindung bezieht sich auf eine Schalt-Vorrichtung mit mehreren Schaltstufen zur Umwandlung einer manuellen und/oder mechanischen Zustellbewegung in ein mindestens elektrisches Schaltsignal, durch das ein elektrisches Gerät gesteuert ist, nach dem Oberbegriff des Patentanspruchs 1.

Eine solche Schalt-Vorrichtung ist bereits aus der DE 10 2009 032 634 A1 vorbekannt. Offenbart ist dort eine Schalt-Vorrichtung zur Umwandlung einer manuellen und/oder mechanischen Zustellbewegung in mindestens ein Schaltsignal, durch die ein elektrisches Gerät gesteuert ist. Zu diesem Zweck weist diese Schalt-Vorrichtung verschiedene mechanische und elektrische Bauteile auf. Ein erstes Schaltsignal wird hierbei durch eine Berührung einer Bedienkappe erzeugt, ein zweites Schaltsignal durch ein Bewegen der Bedienkappe bis zu einer Kontaktposition, in der ein elektrischer Schalter betätigt wird.

Weiter ist aus der DE 10 2015 115 248 eine Schalt-Vorrichtung bekannt, die eine Zustellbewegung in ein entsprechendes elektrisches Schaltsignal umwandelt. Die Schalt-Vorrichtung besteht aus einer ringförmigen Fassung, in der ein elektrisch nichtleitfähiges Tastenteil mit einem Metallkern angeordnet ist, das mittels einer Federeinrichtung in einer Ausgangsposition gehalten ist. Bei einer entsprechenden manuellen Betätigung der Schalt-Vorrichtung ist das Tastenteil mit dem Metallkern in Richtung einer Abdeckplatte bewegt, hinter der sich eine Sensorelektrode befindet, die die Annäherung des Metallkerns des Tastenteils registriert.

Nachteiliger Weise sind diese mechanischen und elektrischen Bauteile fest angeordnet.

Bei einer derartigen Schalt-Vorrichtung handelt es sich um eine Bedien-Vorrichtung bzw. Mensch-Maschine-Schnittstelle, die typischerweise auf einer Abdeckplatte eines berührungssensitiven Bildschirms, auch Touchscreens genannt, angeordnet ist. Die Abdeckplatte des berührungssensitiven Bildschirms ist aus einem transparenten und elektrisch nichtleitfähigen Material hergestellt. Eine Vielzahl von paarweise angeordneten Elektroden bilden einen kapazitiven Flächensensor, der auf die Annäherung oder Berührung eines Gegenstandes, beispielsweise Finger, Hand oder dergleichen, anspricht. Die dabei entstehenden Schaltsignale werden elektronisch verstärkt und zur Steuerung eines elektrischen Gerätes verwendet.

Nachteilig an dieser Schaltvorrichtung ist, dass diese einerseits keine taktile Rückmeldung erzeugt und andererseits, dass eine derartige Schalt-Vorrichtung lediglich ein Schaltsignal generieren kann.

Aus der US 2006/256090 A1 ist eine Schalt-Vorrichtung zur Umwandlung einer manuellen oder mechanischen Zustellbewegung in ein Schaltsignal bekannt. Die Schalt-Vorrichtung weist ein Schaltgehäuse auf, an dem eine Bedienkappe axial in Richtung ihrer Längsachse gegen eine Kontaktfläche eines Sensors verschieblich gelagert ist. Am unteren Ende der Bedienkappe befindet sich ein verformbares, elektrisch leitfähiges Kontaktelement, das sich mit zunehmender Kraft bei Kontakt mit der Kontaktfläche verformt, wobei aus der Größe des Verformungsbereichs auf die Kraft geschlossen werden kann, die auf die Bedienkappe wirkt.

Es ist daher Aufgabe der Erfindung, eine Schalt-Vorrichtung der eingangs genannten Gattung derart weiterzubilden, dass durch diese ein mehrstufiges Schaltsignal in Form einer kapazitiven Dreh-, Schiebe- oder Wippfunktion generiert und auswertbar ist und darüber hinaus soll bei der Betätigung eine taktile Rückmeldung erzeugt werden, durch die der Benutzer erkennt, ob und welche Betätigung gewünscht ist.

Die Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass die Bedienkappe in oder an dem Schaltgehäuse nach Art eines Drehschalters, eines Kippschalters oder einer Wippe rotierbar gelagert gehalten ist und dass eine Drehung und/oder die Verschwenkung der Bedienkappe durch den kapazitiven Flächensensor die Veränderung des elektrischen Feldes erfassbar ist, entsteht ein mehrstufiges und differenzierbares Schaltsignal. Aufgrund der kapazitiven Kopplung zwischen der Bedienkappe und dem Flächensensor ist bereits die Berührung des Gegenstandes, beispielsweise durch einen Finger oder eine Hand, mit der Bedienkappe durch den kapazitiven Flächensensor erfasst und ein elektrisches Schaltsignal wird generiert. Zur Erzeugung des zweiten Schaltsignals ist die Bedienkappe hubartig gedrückt und in Richtung des kapazitiven Flächensensors zugestellt. Das Betätigungselement, das zwischen der Bedienkappe und dem kapazitiven Flächensensor angeordnet ist, wird dadurch elastisch verformt. Der kapazitive Flächensensor erfasst diese Veränderung und kontaktiert eine elektrisch leitfähige Kontaktplatte.

Zwischen der Bedienkappe und dem kapazitiven Flächensensor kann eine elektrisch leitfähige Kontaktplatte angeordnet sein. Die Kontaktplatte ist elektrisch isoliert von dem Betätigungselement und der Bedienkappe im unbetätigten Zustand angeordnet. Bei einer Betätigung der Bedienkappe ist die Bedienkappe mit der Kontaktplatte kurzgeschlossen, so dass die Bedienkappe mittels der Kontaktplatte mit dem kapazitiven Flächensensor kapazitiv gekoppelt ist. Die Kontaktplatte bildet somit nach Art eines Endanschlages die Endposition der Bedienkappe bei der Betätigung. Aufgrund der isolierten Anordnung der Kontaktplatte ist das zweite Schaltsignal ausschließlich bei dem Kurzschluss zwischen der Bedienkappe und der Kontaktplatte generiert. An dem Loslassen der Bedienkappe federt diese durch das Betätigungselement in die Ausgangsposition zurück.

Darüber hinaus ist es besonders vorteilhaft, wenn die Bedienkappe an dem Gehäuse nach Art eines Drehschalters beweglich gelagert gehalten ist und dass eine Drehung der Bedienkappe durch den kapazitiven Flächensensor erfasst ist. Die Drehung des Drehschalters kann beispielsweise durch eine exzentrische Anordnung des Betätigungselementes zwischen der Bedienkappe und dem kapazitiven Flächensensor erfasst werden oder mittels eines Positionsgebers, der an die Bedienkappe angeformt oder angearbeitet ist, und der mit dem kapazitiven Flächensensor derart gekoppelt ist, dass die Drehung der Bedienkappe erfasst ist.

Die Bedienkappe kann weiterhin in oder an dem Gehäuse nach Art eines Schieberegler linear geführt gelagert gehalten sein, so dass durch eine Verschiebung der Bedienkappe beispielsweise Reglerwerte für das elektrische Gerät parametrisiert. Eine Verschiebung der Bedienkappe bzw. des Betätigungselementes ist durch den kapazitiven Flächensensor erfasst und kann beispielsweise durch ein Drücken der Bedienkappe und dem Erzeugen des zweiten elektrische Schaltsignals bestätigt werden.

Die Bedienkappe kann auch als Hebel oder Wippe ausgestaltet sein, die schwenkbar in oder an dem Gehäuse gehalten ist. Durch das Verschenken bzw. die Bewegung der Bedienkappe ist die Position des Betätigungselementes auf dem kapazitiven Flächensensor verändert und durch diesen erfasst, so dass ein Eingabewert bzw. Regelwert bestimmt werden kann.

In der Zeichnung sind zwei erfindungsgemäße Ausführungsbeispiele einer SchaltVorrichtung dargestellt, die nachfolgend näher erläutert sind. Im Einzelnen zeigt:
- Figur 1a: eine beispielhafte Ausführung eine Schalt-Vorrichtung im unbetätigten Zustand, durch die ein mehrstufiges Schaltsignal zur Steuerung eines elektrischen Gerätes generiert ist, mit einem Schaltgehäuse, in das eine Aufnahmeöffnung eingearbeitet ist, einer Abdeckplatte, die aus einem elektrisch leitfähigen Werkstoffen hergestellt und in der Aufnahmeöffnung des Schaltgehäuses axial beweglich gelagert ist, einem als Schnappscheibe ausgeformten Betätigungselement,
- Figur 1b: die Schalt-Vorrichtung gemäß Figur 1a im betätigten Zustand,
- Figur 1c: die Bestandteile der Schalt-Vorrichtung gemäß Figur 1a in einer Explosions-Darstellung,
- Figur 2a: ein erstes Ausführungsbeispiel der Schalt-Vorrichtung gemäß Figur 1a, die als mehrstufige Drehgeber ausgebildet ist,
- Figur 2b: ein zweites Ausführungsbeispiel der Schalt-Vorrichtung gemäß Figur 1a, die als mehrstufiger Schieberegler ausgebildet ist,
- Figur 3a: eine Weiterbildung der Schalt-Vorrichtung gemäß Figur 1a mit drei Schaltstufen,
- Figur 3b: die Schalt-Vorrichtung gemäß Figur 3a im betätigten Zustand bei dem Erreichen der zweiten Schaltstufe,
- Figur 3c: die Schalt-Vorrichtung gemäß Figur 3a bei dem Erreichen der dritten Schaltstufe,
- Figur 4: der Signalverlauf der Schalt-Vorrichtung gemäß Figur 3a und
- Figur 5: ein elektrisches Gerät mit einer Vielzahl von Schalt-Vorrichtungen gemäß den Figuren 1 bis 3c.

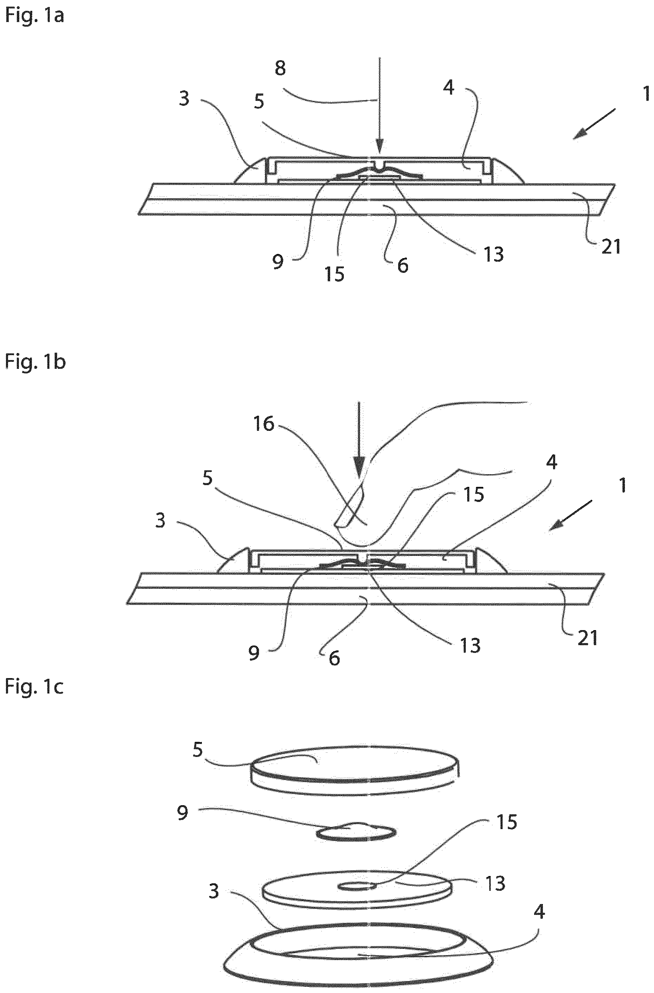

In Figur 1a ist eine Schalt-Vorrichtung 1 zur Umwandlung einer manuelle und/oder mechanischer Zustellbewegung in ein mehrstufiges Schaltsignal 10, 11, 12 durch die ein elektrisches Gerät gesteuert ist, zu entnehmen. Die Schalt-Vorrichtung 1 besteht aus einem Schaltgehäuse 3, in das eine Aufnahmeöffnung 4 eingearbeitet und das aus einem elektrisch nicht-leitfähigen Werkstoff hergestellt ist. Das Schaltgehäuse 3 ist auf einer Abdeckplatte 21 angeordnet, angeklebt oder anderweitig fixiert und auf der dem Schaltgehäuse 3 abgewandten Seite der Abdeckplatte 21 ist ein kapazitiver Flächensensor 6 angeordnet, der ein räumlich wirkendes elektrisches Feld erzeugt und bei einer äußeren Beeinflussung eine kapazitive Auswertung erlaubt. Eine Veränderung des elektrischen Feldes des kapazitiven Flächensensors 6, beispielsweise durch die Betätigung mittels eines Fingers, erzeugt dabei auswertbare elektrische Signaländerungen, durch die die Position des Fingers auf dem kapazitiven Flächensensor 6 bestimmbar ist.

Der kapazitive Flächensensor 6 kann aus einer Vielzahl von Elektrodenpaaren gebildet sein - jedoch aus mindestens einem Elektrodenpaar - die bei einer Bestromung das elektrische Feld erzeugen. Diese Elektrodenpaare können auch als eine Kondensatorschaltung beschrieben werden. Bei einer Störung des elektrischen Feldes des kapazitiven Flächensensors 6 durch einen Gegenstand 2 resultiert die auswertbare elektrische Signaländerung. Der Gegenstand 2 kann beispielsweise eine Hand, ein Finger oder ein vergleichbarer Gegenstand 2 sein, der Teile eines solchen kapazitiven Systems werden kann.

Bei einer Störung des elektrischen Feldes durch den Gegenstand 2, beispielsweise bei der Betätigung mittels eines Fingers, bewirken die betroffenen Elektroden folglich in dem kapazitiven Flächensensor 6 die Änderung des elektrischen Signals des kapazitiven Flächensensors 6. Diese auswertbare elektrische Signaländerung entspricht eines der Schaltsignale 10, 11, 12.

In der Aufnahmeöffnung 4 der Schalt-Vorrichtung 1 ist auf der der Abdeckplatte 21 abgewandten Seite eine Bedienkappe 5 entlang der Längsachse 8 beweglich gelagert. Die Bedienkappe 5 ist aus einem elektrisch leitfähigen Werkstoff hergestellt und ist federnd an einem leitfähigen Betätigungselement 9 abgestützt und mit diesem elektrisch verbunden. Das Betätigungselement 9 kann als eine Schnappscheibe ausgebildet sein und ist vorzugsweise aus einem metallischen Werkstoff hergestellt, so dass bei einer Berührung des Gegenstandes 2 mit der Bedienkappe 5 eine kapazitive Kopplung zwischen dem Gegenstand 2 und dem kapazitiven Flächensensor 6 mittels der Bedienkappe 5 und dem Betätigungselement 9 entsteht. Hierzu befindet sich das Betätigungselement 9 bereichsweise in dem elektrischen Feld des kapazitiven Flächensensors 6.

Das in diesem Ausführungsbeispiel als Schnappscheibe ausgebildete Betätigungselement 9 ist kuppelartig auf einem dünnwandigen elektrisch isolierenden Träger 13 abgestützt und in dem von dem Träger 13 und dem Betätigungselement 9 eingeschlossen Raum ist eine Kontaktplatte 15 angeordnet. Der Träger 13 kann aus einer Kunststofffolie hergestellt sein und lichtdurchlässig sein, dass dieser auch als Lichtleiter zur visuellen Wahrnehmung der Schalt-Vorrichtung 1 beitragen kann.

Die Kontaktplatte 15 ist in dem unbetätigten Zustand der Schalt-Vorrichtung 1 elektrisch isoliert und folglich beabstandet von der Bedienkappe 5 und von dem Betätigungselement 9 in dem Wirkbereich des elektrischen Feldes des Flächensensors 6 angeordnet.

Im betätigten Zustand, dargestellt in Figur 1b, der Schalt-Vorrichtung 1 ist die Bedienkappe 5 entlang der Längsachse 8 verschoben, durch die die Zustellrichtung definiert ist. Durch die elastischen Eigenschaften des Betätigungselementes 9 ist dieses derart verformt, dass eine elektrische Verbindung oder Koppelung zwischen der Bedienkappe 5 und der Kontaktplatte 15 entsteht. Die Kontaktplatte 15 vergrößert somit die elektrische Kopplung mit dem kapazitiven Flächensensor 6. Diese elektrische Kopplung in der zweiten Schaltstufe ist im Vergleich zu der elektrischen Kopplung in der ersten Schaltstufe, die ausschließlich durch das Betätigungselement 9 zustande kommt, größer und erzeugt somit unterschiedliche und damit differenzierbare Schaltsignale 10, 11. Der Gegenstand 2 ist nämlich einerseits im unbetätigten Zustand mit dem kapazitiven Flächensensor 6 und der Bedienkappe 5 und des Betätigungselementes 9 und andererseits im betätigten Zustand mittels der Bedienkappe 5, des Betätigungselementes 9 und der Kontaktplatte 15 elektrisch gekoppelt. Durch die elektrische Kopplung der Kontaktplatte 15 mit der Bedienkappe 5 beeinflusst die Kontaktplatte 15 das elektrische Feld des kapazitiven Flächensensors 6 und ein zweites Schaltsignal 11 wird dabei generiert. Dieses zweite Schaltsignal 11 ist von dem ersten Schaltsignal 10 differenzierbar.

Um eine gute Differenzierbarkeit der beiden elektrischen Schaltsignale 10, 11 zu erreichen, sind die effektiven Flächen in dem elektrischen Feld des kapazitiven Flächensensors 6 des Betätigungselements 9 und der Kontaktplatte 15 unterschiedlich groß bemessen. Aufgrund der unterschiedlich groß bemessenen effektiven Flächen des Betätigungselements 9 und der Kontaktplatte 15 wird das elektrische Feld des kapazitiven Flächensensors 6 mehr oder weniger stark beeinflusst und es können mehrere Schaltstufen realisiert werden.

Die taktile und akustische Rückmeldung der Schalt-Vorrichtung 1 ist durch die mechanischen Eigenschaften des Betätigungselements 9 erreicht, das nämlich als Schnappscheibe ausgestaltet ist. In der ersten Schaltstufe der Schalt-Vorrichtung 1 befindet sich die Schnappscheibe im statisch stabilen Zustand. Das Schaltsignal 10 wird bei der Berührung der Bedienkappe 5 erzeugt. Beim Drücken oder Zuschalten der Bedienkappe 5 ist die Schnappscheibe schlagartig in ihren betätigten Zustand überführt und erzeugt eine taktil und akustisch wahrnehmbare Rückmeldung bei dem Erreichen der zweiten Schaltstufe. Diese schlagartige Verformung des Betätigungselementes 9 in Richtung des kapazitiven Flächensensors 6 erzeugt den elektrischen Kurzschluss zwischen dem Betätigungselement 9 und der Kontaktplatte 15. Nach der Betätigung und dem Loslassen der Bedienkappe 5 ist diese durch die Vorspannung des Betätigungselementes 9 in die Ausgangsposition zurückgeführt.

Die einzelnen Komponenten der Schalt-Vorrichtung 1 sind insbesondere der Explosionszeichnung in Figur 1c zu entnehmen.

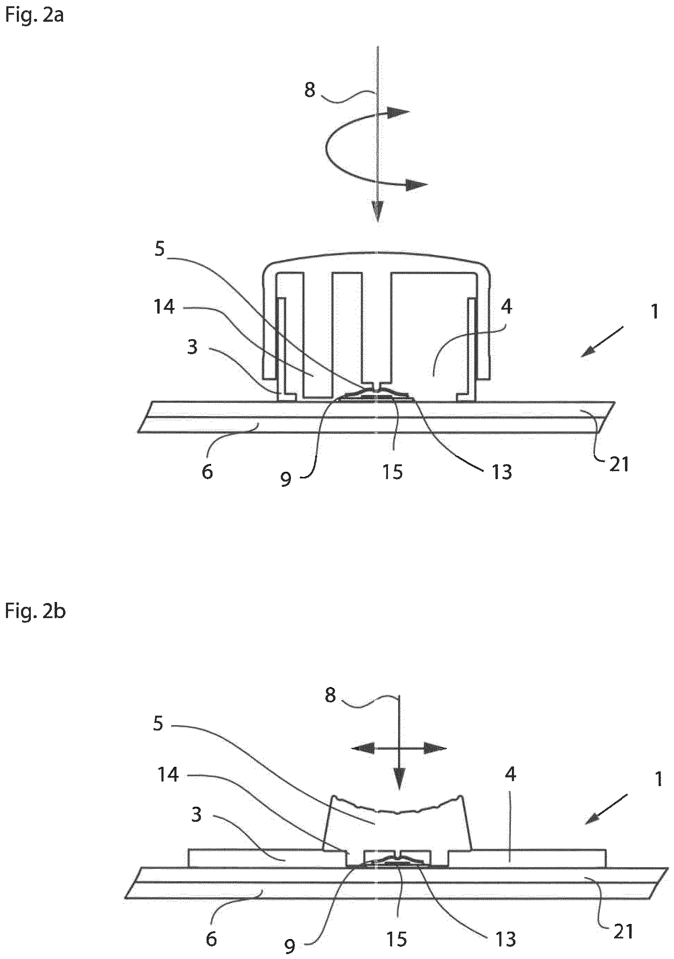

In Figur 2a ist eine zweistufige Schalt-Vorrichtung 1 dargestellt, die als Drehgeber ausgebildet ist. Eine derartige Schalt-Vorrichtung 1 kann beispielsweise dazu verwendet werden, durch eine Drehbewegung einen Regelwert vorzugeben und durch ein Drücken bzw. Betätigen der Bedienkappe 5 den durch die Drehbewegung vorgegebenen Regelwert zu bestätigen.

Die Bedienkappe 5 ist entlang der Längsachse 8 axialbeweglich und um die Längsachse 8 rotierbar an dem Schaltgehäuse 3 gelagert. Auf der dem kapazitiven Flächensensor 6 zugewandten Seite der Bedienkappe 5 ist ein Positionsgeber 14 parallel und beanstandet zu der Längsachse 8 - also exzentrisch - angeordnet, dessen Position relativ zu dem kapazitiven Flächensensor 6 durch den kapazitiven Flächensensor 6 aufgrund einer kapazitiven Kopplung erfasst werden kann. Der Positionsgeber 14 ist hierzu aus einem elektrisch leitfähigen Werkstoff hergestellt und elektrisch gekoppelt an die Bedienkappe 5 angearbeitet oder angeformt.

Die Drehposition bzw. die Regelwertvorgabe der Schalt-Vorrichtung 1 ist bei der Berührung der Bedienkappe 5 mit dem Gegenstand 2 erfasst. Dies entspricht der ersten Schaltstufe. In dieser ist einerseits durch die Berührung des Gegenstandes 2, beispielsweise einer Hand oder eines Fingers, das erste Schaltsignal 10 erzeugt ist und andererseits ist die Drehposition / Winkelposition der Bedienkappe 5 erfasst.

Die zweite Schaltstufe der Schalt-Vorrichtung 1 ist durch die Zustellbewegung der Bedienkappe 5 entlang der Längsachse 8 erreicht. Die Schnappscheibe bzw. das Betätigungselement 9 verbindet Bedienkappe 5 mit dem unterhalb des Betätigungselementes 9 angeordneten Kontaktplatte 15, wodurch das zweite Schaltsignal 15 generiert ist.

Aufgrund der unterschiedlichen Positionierung und der unterschiedlich starken Beeinflussung des elektrischen Feldes des kapazitiven Flächensensors 6, sind die beiden elektrischen Schaltsignale 10, 11 eindeutig differenzierbar.

Aus Figur 2b ist eine mehrstufige Schalt-Vorrichtung 1 zu entnehmen, die als Slider bzw. Schieberegler ausgebildet ist. Die Bedienkappe 5 ist hubbeweglich entlang der Längsachse 8 und entlang einer Achse senkrecht zu der Längsachse 8 in dem Schaltgehäuse 3 beweglich gelagert gehalten. Auf der dem kapazitiven Flächensensor 6 zugewandten Seite der Bedienkappe 5 ist der Positionsgeber 14 angeordnet, der mit dem kapazitiven Flächensensor 6 kapazitiv gekoppelt ist. Der Positionsgeber 14 bzw. Schalt-Vorrichtung 1 verhält sich so lange neutral, bis ein Gegenstand 2 die Bedienkappe 5 berührt und durch die kapazitive Kopplung zwischen dem Gegenstand 2 und dem kapazitiven Flächensensor 6 das Schaltsignal 10 generiert ist.

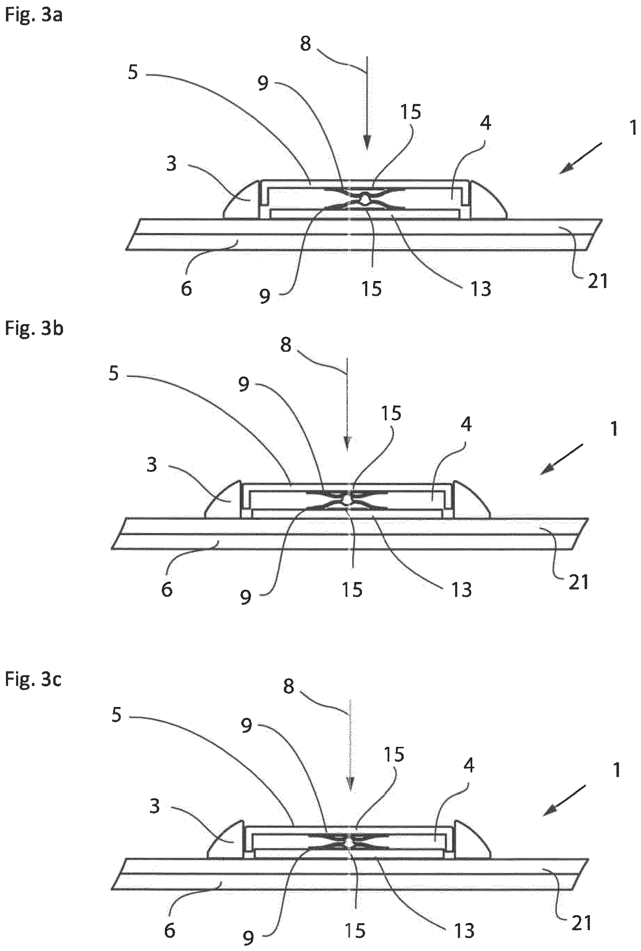

In den Figuren 3a bis 3c ist eine Schalt-Vorrichtung 1 mit drei Schaltstufen dargestellt. Die drei Schaltstufen der Schalt-Vorrichtung 1 werden durch eine Art Reihenschaltung von zwei als Schnappscheibe ausgebildeten Betätigungselementen 9 bewerkstelligt, die unterschiedliche mechanische Eigenschaften aufweisen, so dass diese sequenziell - also zeitlich nacheinander - beim Betätigen der Schalt-Vorrichtung 1 in Abhängigkeit von dem Hub der Bedienkappe 5 eine wahrnehmbare Rückmeldung geben.

Die beiden Betätigungselemente 9 sind aus einem elektrisch leitfähigen Material hergestellt. Die kuppelförmigen als Schnappscheibe ausgebildeten Betätigungselemente 9 sind spiegelsymmetrisch zueinander angeordnet und elektrisch miteinander verbunden. In den durch die kuppelform der Betätigungselemente 9 gebildeten Hohlräume sind jeweils eine Kontaktplatte 15 angeordnet, die in dem unverformten Zustand des jeweiligen Betätigungselements 9 zu diesem elektrisch isoliert angeordnet sind.

Das erste Schaltsignal 10 ist analog zu den bereits vorgestellten Ausführungsbeispielen bei der Berührung der Bedienkappe 5 mit dem Gegenstand 2 erzeugt. Die kapazitive Kopplung des kapazitiven Flächensensors 6 mit dem Gegenstand 2 erfolgt dabei durch die Bedienkappe 5 und den Betätigungselementen 9. Das zweite Schaltsignal 11 ist bei einer manuellen Betätigung der Bedienkappe 5 und einem vorgegebenen Hub generiert. Aufgrund der Zustellbewegung ist zunächst eines der Betätigungselemente 9 schlagartig in den betätigten Zustand überführt und eine nach Art einer Parallelschaltung ist eine kapazitive Kopplung zwischen dem Betätigungselement 9 und der Kontaktplatte 15 hergestellt, die zu einer elektrisch erfassbaren Änderung des elektrischen Feldes des kapazitiven Flächensensors 6 führt. Ein drittes Schaltsignal 12 ist bei einer weiteren Zustellbewegung der Bedienkappe 5 generiert, wenn auch das zweite Betätigungselement 9 in den betätigten Zustand überführt ist. Dieser Zustand entspricht der dritten Schaltstufe, dargestellt in Figur 3c. Diese Schaltstufe wird analog zur zweiten Schaltstufe mittels der unter dem zweiten Betätigungselement 9 angeordneten zweiten Kontaktplatte 15 hergestellt. Diese Änderung in dem elektrischen Feld des kapazitiven Flächensensors 6 ist durch diesen erfasst und ein drittes Schaltsignal 12 ist generiert.

Durch die elektrischen Eigenschaften der Betätigungselemente 9 und der Kontaktplatten 15 sowie der Anordnung der Betätigungselemente 9 und der Kontaktplatten 15 ist erreicht, dass das elektrische Feld des kapazitive Flächensensors 6 unterschiedlich beeinflusst ist.

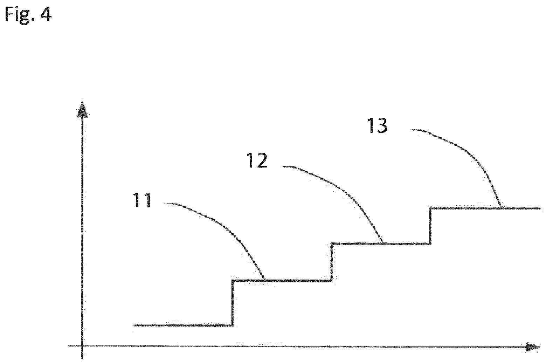

Ein Signalverlauf einer dreistufigen Schalt-Vorrichtung 1 ist der Figur 4 zu entnehmen. Es ist ersichtlich, dass die Schaltsignale 10, 11, unterschiedliche Signalwerte aufweisen und der Signalverlauf zwischen den Schaltsignalen 10, 11, 12 sprungartig verläuft. Dieser scharfkantige und sprungartige Signalverlauf ist dadurch erreicht, dass die jeweilige Kontaktplatte 15 zunächst elektrisch abschirmende Eigenschaften aufweist und schlagartig bei einem Kurzschluss mit dem Betätigungselement 9 die die kapazitive Kopplung mit dem kapazitiven Flächensensor 6 verändert. Dieser scharfkantige Spannungsverlauf ist insbesondere vorteilhaft, um eine gute Differenzierbarkeit zwischen den Schaltsignalen 10, 11, 12 zu erreichen.

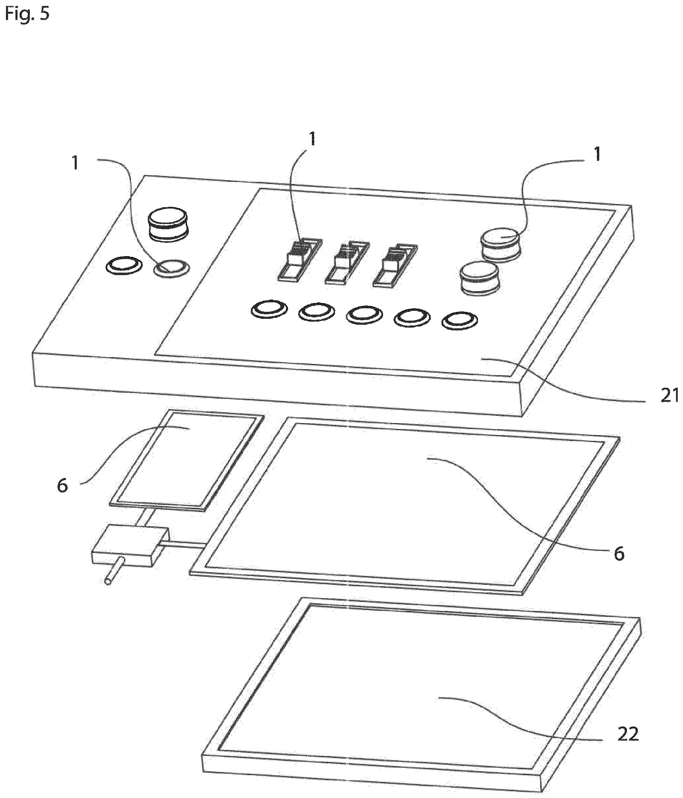

In Figur 5 ist ein elektrisches Gerät mit einer Vielzahl von elektrischen Schaltvorrichtungen 1 zu entnehmen. Auf dem elektrischen Gerät sind die elektrischen Schaltvorrichtungen 1 als Schieberegler bzw. Slider, Drehgeber und als mehrstufige Taster ausgebildet. Das elektrische Gerät kann aus einer Vielzahl von kapazitiven Flächensensoren 6 gebildet sein, die durch eine oder mehrere voneinander getrennte oder miteinander mechanisch gekoppelten Abdeckplatten 21 versehen sind. Auf der der Schaltvorrichtungen1 abgewandten Seite der Abdeckplatte 21 ist eine Anzeigeeinheit 22 angeordnet, die beispielsweise als Braunsche Röhre, TFT- oder LCD-Anzeige ausgebildet sein kann.

## Patentansprüche

1. Schalt-Vorrichtung (1) zur Umwandlung einer manuellen und/oder mechanischen Zustellbewegung in mindestens ein Schaltsignal (10), durch die ein elektrisches Gerät gesteuert ist, bestehend aus:
- einem Schaltgehäuse (3), in das eine Aufnahmeöffnung (4) eingearbeitet ist,
- einer Bedienkappe (5), die aus einem elektrisch leitfähigen Werkstoff hergestellt und an oder in der Aufnahmeöffnung (4) des Schaltgehäuses (5) entlang einer Längsachse, durch die die Zustellrichtung (8) definiert ist, beweglich gelagert ist,
- einem kapazitiven Flächensensor (6), der zur kapazitiven Auswertung ein räumlich wirkendes elektrisches Feld erzeugt und der auf der in Zustellrichtung (8) gegenüberliegenden Seite der Bedienkappe (5) angeordnet ist und bei einer Änderung des elektrischen Feldes ein Schaltsignal (10) generiert, und
- mindestens einem zwischen der Bedienkappe (5) und dem kapazitiven Flächensensor (6) vorgesehenen Betätigungselement (9), das elektrisch leitfähig und elastisch verformbar ist, durch das mindestens eine kapazitive Kopplung zwischen der Bedienkappe (5) und dem kapazitiven Flächensensor (6) entsteht,
wobei das Schaltgehäuse (3) auf einer Abdeckplatte angeordnet, angeklebt oder anderweitig fixiert ist und der kapazitive Flächensensor (6) außerhalb des Schaltgehäuses (3) auf der dem Schaltgehäuse (3) abgewandten Seite der Abdeckplatte (21) angeordnet ist und bei einer äußeren Beeinflussung eine kapazitive Auswertung erlaubt, wobei die Bedienkappe (5) in oder an dem Schaltgehäuse (3) entweder nach Art eines Drehschalters, eines Kippschalters, eines Hebels oder einer Wippe rotierbar gelagert gehalten ist und dass durch die Drehung oder Verschwenkung der Bedienkappe (5) durch den kapazitiven Flächensensor (6) eine Veränderung des elektrischen Feldes erfassbar ist, oder nach Art eines Schiebeschalters oder Schieberegler linear beweglich gelagert gehalten ist und dass die Schiebe-Bewegung der Bedienkappe (5) durch den kapazitiven Flächensensor (6) erfassbar ist, wobei durch das Betätigungselement (9) das erste elektrische Schaltsignal (10) bei einer Berührung der Bedienkappe (5) mithilfe des kapazitiven Flächensensors (6) generiert ist und dass bei einer Zustellbewegung der Bedienkappe (5) mindestens ein zweites differenzierbares elektrisches Schaltsignal (11, 12) mithilfe des kapazitiven Flächensensors (6) gebildet ist.

2. Schalt-Vorrichtung (1) nach Anspruch 1,
**dadurch gekennzeichnet,**
**dass** mindestens ein Positionsgeber (14) an der Bedienkappe (5) angearbeitet oder angeformt ist und dass der Positionsgeber (14) mit dem kapazitiven Flächensensor (6) kapazitiv gekoppelt ist.

## Claims

1. Switching device (1) for converting a manual and/or mechanical movement into at least one switching signal (10), by means of which an an electrical device, comprising:
- a switching housing (3) with a mounting opening (4)
- an operating cap (5) made of an electrically conductive material and mounted movably on or in the receiving opening (4) of the switch housing (5) along a longitudinal axis through which the feed direction (8) is defined,
- a capacitive surface sensor (6) which generates a spatially acting electric field for capacitive evaluation and which is arranged on the side of the operating cap (5) opposite the feed direction (8) and generates a switching signal (10) when the electric field changes, and
- at least one actuating element (9) provided between the operating cap (5) and the capacitive surface sensor (6), which is electrically conductive and elastically deformable, whereby at least one capacitive coupling is created between the operating cap (5) and the capacitive surface sensor (6),
wherein the switch housing (3) is arranged, glued, or otherwise fixed on a cover plate, and the capacitive surface sensor (6) is arranged outside the switch housing (3) on the side of the cover plate (21) facing away from the switch housing (3) and allows capacitive evaluation in the event of external influence, wherein the operating cap (5) is mounted in or on the switch housing (3) so that it can rotate, either in the manner of a rotary switch, a toggle switch, a lever, or a rocker, and that the rotation or swiveling of the operating cap (5) by the capacitive surface sensor (6), a change in the electric field can be detected, or is mounted so that it can be moved linearly in the manner of a slide switch or slide control, and that the sliding movement of the operating cap (5) can be detected by the capacitive surface sensor (6), wherein the first electrical switching signal (10) is generated by the actuating element (9) when the operating cap (5) is touched with the aid of the capacitive surface sensor (6), and that at least one second differentiable electrical switching signal (11, 12) is generated with the aid of the capacitive surface sensor (6).

2. Switching device (1) according to claim 1,
**characterized in that**
**in that** at least one position sensor (14) is attached to or molded onto the operating cap (5) and **in that** the position sensor (14) is capacitively coupled to the capacitive area sensor (6).

## Revendications

1. Dispositif de commutation (1) pour convertir un mouvement de commutation manuel et/ou mécanique
en au moins un signal de commutation (10), par lequel un
appareil électrique est commandé, comprenant :
- un boîtier de commutation (3) dans lequel est pratiquée une ouverture de réception (4),
- un capuchon de commande (5) fabriqué à partir d'un matériau électriquement conducteur et monté de manière mobile sur ou dans l'ouverture de réception (4) du boîtier de commutation (5) le long d'un axe longitudinal qui définit la direction d'avance (8),
- un capteur capacitif plat (6) qui génère un champ électrique agissant dans l'espace pour l'évaluation capacitive et qui est disposé sur le côté du capuchon de commande (5) opposé à la direction d'avance (8) et génère un signal de commutation (10) en cas de modification du champ électrique, et
- au moins un élément d'actionnement (9) prévu entre le capuchon de commande (5) et le capteur capacitif à surface (6), qui est électriquement conducteur et élastiquement déformable, et qui crée au moins un couplage capacitif entre le capuchon de commande (5) et le capteur capacitif à surface (6),
le boîtier de commutation (3) étant disposé, collé ou fixé d'une autre manière sur une plaque de recouvrement et le capteur capacitif plat (6) étant disposé à l'extérieur du boîtier de commutation (3) sur le côté de la plaque de recouvrement (21) opposé au boîtier de commutation (3) et permet une évaluation capacitive en cas d'influence extérieure, le capuchon de commande (5) est monté de manière rotative dans ou sur le boîtier de commutation (3), soit à la manière d'un commutateur rotatif, d'un interrupteur à bascule, d'un levier ou d'une bascule, et que la rotation ou le pivotement du capuchon de commande (5) permet de détecter une modification du champ électrique par le capteur de surface capacitif (6), ou est monté de manière à pouvoir se déplacer linéairement à la manière d'un interrupteur à coulisse ou d'un curseur, et que le mouvement de coulissement du capuchon de commande (5) peut être détecté par le capteur capacitif de surface (6), le premier signal de commutation électrique (10) étant généré par l'élément d'actionnement (9) lors d'un contact avec le capuchon de commande (5) à l'aide du capteur capacitif de surface (6) et au moins un deuxième signal de commutation électrique différenciable (11, 12) est généré à l'aide du capteur capacitif de surface (6).

2. Dispositif de commutation (1) selon la revendication 1,
**caractérisé en ce qu'**
qu'au moins un capteur de position (14) est monté ou moulé sur le capuchon de commande (5) et que le capteur de position (14) est couplé de manière capacitive au capteur de surface capacitif (6).
